# EUROPÄISCHE PATENTSCHRIFT

(11) **EP 0 818 877 B1**
(45) Veröffentlichungstag und Bekanntmachung des Hinweises auf die Patenterteilung: **19.02.2003**
(21) Anmeldenummer: 97110514.3
(22) Anmeldetag: 26.06.1997
(51) Int. Cl.: H03F 1/32

(54) **Schaltungsanordnung zur Offset-Kompensation**
Offset compensation circuit
Circuit de compensation du décalage

(30) Priorität: 12.07.1996 DE 19628257
(43) Veröffentlichungstag der Anmeldung: 14.01.1998
(73) Patentinhaber: Infineon Technologies AG, 81669 München (DE)
(72) Erfinder: Weber, Stephen, Dr.-Ing., 81739 München (DE); Thomas, Volker, Dr.-Ing., 81245 München (DE)
(74) Vertreter: Epping Hermann & Fischer

(56) Entgegenhaltungen:
- GB-A- 2 111 780

## Beschreibung

Die Erfindung betrifft eine Schaltungsanordnung zur Offset-Kompensation mit einer Filtereinrichtung zur Ermittlung des Gleichanteils in einem ihr zugeführten Eingangssignal und mit einer Verknüpfungseinrichtung zur subtraktiven Verknüpfung des Eingangssignals und des Ausgangssignals der Filtereinrichtung.

Eine derartige Schaltungsanordnung ist beispielsweise aus der Firmenschrift von Linear Technology Corporation, Linear Applications Handbook 1987, Seite AN21-1 bekannt. Bei der darin beschriebenen Schaltungsanordnung wird das Eingangssignal zum einen direkt auf den invertierenden Eingang eines Operationsverstärkers geführt und zum anderen unter Zwischenschaltung eines Tiefpasses an den nichtinvertierenden Eingang des Operationsverstärkers gelegt. Der Tiefpaß hat eine verhältnismäßig niedrige Grenzfrequenz, so daß im wesentlichen nur Gleichanteile an den nichtinvertierenden Eingang des Operationsverstärkers gelangen. Demzufolge erfolgt mittels des Tiefpasses die Gleichstromarbeitspunkteinstellung des Operationsverstärkers, während über den invertierenden Eingang der eigentliche Signalpfad verläuft.

Problematisch ist jedoch bei großen Gleichanteilen, daß der Operationsverstärker gleichstrommäßig übersteuert wird und demzufolge eine größere Einschwingzeit benötigt. Um dies zu verhindern, ist bei der bekannten Schaltungsanordnung ein Spannungsteiler dem nichtinvertierenden Eingang des Operationsverstärkers vorgeschaltet. Häufig ist es aber notwendig, daß die Offset-Kompensation bis zur Arbeitsbereichsgrenze des Operationsverstärkers möglichst präzise arbeiten und außerhalb des Arbeitsbereichs scharf begrenzen sollte. Jedes weitere Entfernen von dieser Grenze würde nur die Einschwingzeit verschlechtern und jede Nichtlinearität nahe der Bereichsgrenze würde zu Ungenauigkeiten führen. Diese Anforderungen sind jedoch mit einem Spannungsteiler wie bei der bekannten Schaltungsanordnung nicht zu erreichen.

Aufgabe der Erfindung ist es, eine Schaltungsanordnung der eingangs genannten Art anzugeben, die diese Nachteile nicht aufweist.

Die Aufgabe wird durch eine Schaltungsanordnung gemäß Patentanspruch 1 gelöst. Ausgestaltungen und Weiterbildungen des Erfindungsgedankens sind Gegenstand von Unteransprüchen.

Bei der erfindungsgemäßen Schaltungsanordnung wird der Genauigkeitsgewinn und die Begrenzung der maximalen Einschwingzeit mit nur geringem zusätzlichen schaltungstechnischen Aufwand erreicht. Im einzelnen wird bei einer gattungsgemäßen Schaltungsanordnung dazu anstelle des Spannungsteilers eine Track- und Hold-Einrichtung zwischen Filtereinrichtung und Verknüpfungseinrichtung geschaltet, die mittels eines Steuersignals steuerbar ist. Das Steuersignal wird durch eine Fensterkomparatoreinrichtung bereitgestellt, an deren Eingang das Eingangssignal angelegt ist. Die Trackund Hold-Einrichtung befindet sich für den Fall, daß das Eingangssignal innerhalb eines vorgegebenen Fensters liegt, im Trackmodus und ansonsten im Holdmodus.

Bei einer Weiterbildung der Erfindung ist vorgesehen, daß das Fenster dem Arbeitsbereich weiterer Schaltungsteile entspricht.

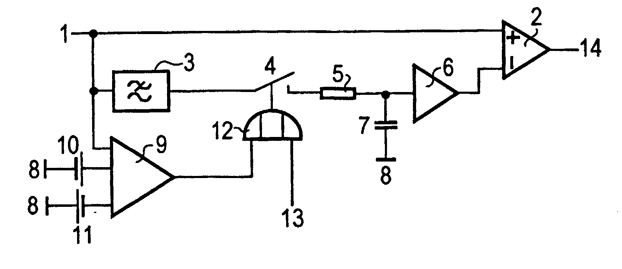

Die Erfindung wird nachfolgend anhand des in der einzigen Figur der Zeichnung dargestellten Ausführungsbeispiels näher erläutert.

Bei der als Ausführungsbeispiel gezeigten erfindungsgemäßen Schaltungsanordnung zur Offset-Kompensation wird ein Eingangssignal 1, dessen Gleichanteil sich stetig und sehr langsam ändert, dem nichtinvertierenden Eingang eines Komparators 2 zugeführt. Mittels des Komparators 2 soll dabei festgestellt werden, ob die Augenblicksamplitude des Wechselanteils beispielsweise größer oder kleiner 0 ist. Aufgrund des überlagerten Gleichanteils beim Eingangssignal 1, ist das an den invertierenden Eingang des Komparators 2 anzulegende Vergleichssignal derart zu bemessen, daß der Gleichanteil kompensiert wird.

Zur Kompensation ist ein Tiefpaßfilter 3 vorgesehen, dem das Eingangssignal 1 zugeführt wird. Die Grenzfrequenz des Tiefpaßfilters 3 ist dabei derart niedrig gewählt, daß im wesentlichen nur die Gleichanteile durchgelassen werden. Dem Tiefpaßfilter 3 ist eine Track- und Hold-Einrichtung nachgeschaltet, die beim Ausführungsbeispiel aus einem steuerbaren Schalter 4, einem in Reihe zum Schalter 4 liegenden Widerstand 5, einem in Reihe dazu geschalteten Pufferverstärker 6 sowie einem Kondensator 7, der einerseits an den Knotenpunkt von Widerstand 5 und Pufferverstärker 6 und zum anderen an ein Bezugspotential 8 angeschlossen ist. Der den Ausgang der Track- und Hold-Einrichtung bildende Ausgang des Pufferverstärkers 6 ist dabei mit dem invertierenden Eingang des Komparators 2 verbunden.

Die Steuerung des Schalters 4 erfolgt hauptsächlich durch einen Fensterkomparator 9, an dessen Eingang das Eingangssignal 1 angelegt ist und dessen Fenster durch zwei jeweils zwischen den Fensterkomparator und das Bezugspotential 8 geschaltete Referenzspannungsquellen 10 und 11 bestimmt wird. Die Spannungen der beiden Referenzspannungsquellen 10 und 11 sind dabei derart bemessen, daß das durch sie festgelegte Fenster dem Arbeitsbereich weiterer Schaltungsteile, wie beispielsweise dem Komparator 2, entspricht. Schließlich ist noch ein ODER-Gatter 12 vorgesehen, dessen einer Eingang mit dem Ausgang des Fensterkomparators 9 verbunden ist, an dessen anderen Eingang ein externes Steuersignal 13 angelegt ist und an dessen Ausgang das Steuersignal für den steuerbaren Schalter 4 bereitsteht. Das externe Steuersignal 13 erlaubt es, unabhängig vom Fensterkomparator 9 den Augenblickswert des Ausgangssignals des Tiefpasses 3 einzufrieren.

Beim Ausführungsbeispiel erfolgt die Bereichskontrolle des Komparators 2 also durch einen Fensterkomparator, dessen Ausgang mit dem Steuereingang der Track- und Hold-Einrichtung verknüpft wird. So lange der Gleichanteil innerhalb der vorgegebenen Grenzen bleibt, arbeitet die Track- und Hold-Einrichtung im Trackmode, d.h. das Ausgangssignal des Tiefpasses 3 ist im wesentlichen auf den invertierenden Eingang des Komparators 2 aufgeschaltet. Wenn jedoch die Grenzen überschritten werden, wird auf den Holdmodus umgeschaltet, so daß der Arbeitsbereich des Komparators 2 nur geringfügig verlassen wird. Das Ausgangssignal 14 des Komparators 2 hat daher über dessen gesamten Arbeitsbereich die gleich hohe Genauigkeit. Zudem wird nach einem Verlassen des Arbeitsbereiches und einem Wiedereintritt diese hohe Genauigkeit in kurzer Zeit wiedererlangt. Dies ergibt sich aus der hohen Linearität innerhalb der Bereichsgrenzen sowie aus der durch die Track- und Hold-Einrichtung bedingten scharfen Begrenzung. Die erfindungsgemäße Schaltungsanordnung kann anstelle des gezeigten Komparators auch in Verbindung mit Verstärkern und anderen Schaltungselementen in gleicher Weise als subtraktive Koppel-/Verknüpfungseinrichtung vorteilhaft eingesetzt werden. Insbesondere beim Betrieb mit niedrigen Versorgungsspannungen zeichnet sich dabei die erfindungsgemäße Schaltungsanordnung durch hohe Genauigkeit und Stabilität aus.

## Patentansprüche

1. Schaltungsanordnung zur Offset-Kompensation mit einer Filtereinrichtung (3) zur Ermittlung des Gleichanteils in einem ihr zugeführten Eingangssignal (1) und mit einer Verknüpfungseinrichtung (2) zur subtraktiven Verknüpfung des Eingangssignals (1) und des Ausgangssignals der Filtereinrichtung (3),
**dadurch gekennzeichnet, daß** zwischen Filtereinrichtung (3) und Verknüpfungseinrichtung (2) eine Track- und Hold-Einrichtung (4, 5, 6, 7) geschaltet ist, die mittels eines Steuersignals steuerbar ist, und daß das Steuersignal durch eine Fensterkomparatoreinrichtung (9) bereitgestellt wird, an deren Eingang das Eingangssignal (1) angelegt ist, wobei die Track- und Hold-Einrichtung (4, 5, 6, 7) für den Fall, daß das Eingangssignal innerhalb eines vorgegebenen Fensters liegt, sich im Trackmodus und ansonsten im Holdmodus befindet.

2. Schaltungsanordnung nach Anspruch 1,
**dadurch gekennzeichnet, daß** das Fenster dem Arbeitsbereich weiterer Schaltungsteile entspricht.

## Claims

1. Circuit arrangement for offset compensation having a filter device (3) for determining the DC component in an input signal (1) which is supplied to it, and having a logic linking device (2) for subtractive logic linking of the input signal (1) and of the output signal of the filter device (3),
**characterized in that** a track and hold device (4, 5, 6, 7) is connected between the filter device (3) and the logic linking device (2) and can be controlled by means of a control signal, and **in that** the control signal is produced by a window comparator device (9) to whose input the input signal (1) is applied, with the track and hold device (4, 5, 6, 7) being in the track mode in the situation where the input signal is within a predetermined window, and otherwise being in the hold mode.

2. Circuit arrangement according to Claim 1,
**characterized in that** the window corresponds to the operating range of further circuit parts.

## Revendications

1. Circuit pour la compensation de décalage ayant un dispositif de filtrage (3) pour la détermination de la composante continue dans un signal d'entrée (1) qui lui est envoyé et ayant un dispositif de combinaison (2) pour la combinaison soustractive du signal d'entrée (1) et du signal de sortie du dispositif de filtrage (3),
**caractérisé par le fait qu'**il est branché entre le dispositif de filtrage (3) et le dispositif de combinaison (2) un dispositif de poursuite et de maintien (4, 5, 6, 7) qui peut être commandé au moyen d'un signal de commande et que le signal de commande est fourni par un dispositif comparateur à fenêtre (9) à l'entrée duquel le signal d'entrée (1) est appliqué, le dispositif de poursuite et de maintien (4, 5, 6, 7) se trouvant en mode poursuite si le signal d'entrée est à l'intérieur d'une fenêtre prédéterminée et en mode maintien sinon.

2. Circuit selon la revendication 1, **caractérisé par le fait que** la fenêtre correspond à la plage de fonctionnement d'autres parties de circuit.
